(19) Europäisches Patentamt

European Patent Office

Office européen des brevets

(11) **EP 0 966 553 B1**

(12) **EUROPEAN PATENT SPECIFICATION**

(45) Date of publication and mention
of the grant of the patent:
**24.03.2004 Bulletin 2004/13**

(21) Application number: **98963040.5**

(22) Date of filing: **10.12.1998**

(51) Int Cl.$^7$: **C23C 16/40**, H01L 29/00,
C23C 18/12, C30B 25/02

(86) International application number:
**PCT/US1998/026257**

(87) International publication number:
**WO 1999/029926 (17.06.1999 Gazette 1999/24)**

(54) **PROCESS FOR LOW TEMPERATURE CVD USING BI-AMIDES**

VERFAHREN ZUR CVD BEI NIEDRIGEN TEMPERATUREN UNTER VERWENDUNG VON BI-AMIDEN

PROCEDES DE DCPV A BASSE TEMPERATURE AVEC UTILISATION DE BIAMIDES

(84) Designated Contracting States:
**DE FR GB IE IT NL**

(30) Priority: **10.12.1997 US 69041 P**

(43) Date of publication of application:
**29.12.1999 Bulletin 1999/52**

(73) Proprietors:
• **Infineon Technologies AG**
**81669 München (DE)**
• **ADVANCED TECHNOLOGY MATERIALS, INC.**
**Danbury, CT 06810 (US)**

(72) Inventors:
• **HINTERMAIER, Frank**
**D-81373 München (DE)**
• **VAN BUSKIRK, Peter**
**Newtown, CT 06470 (US)**
• **ROEDER, Jeffrey, R.**
**Brookfield, CT 06806 (US)**
• **HENDRIX, Bryan**
**Danbury, CT 06810 (US)**
• **BAUM, Thomas, H.**
**New Fairfield, CT 06812 (US)**
• **DESROCHERS, Debra, A.**
**Brookfield, CT 06804 (US)**

(74) Representative: **Patentanwälte
Westphal, Mussgnug & Partner
Am Riettor 5
78048 Villingen-Schwenningen (DE)**

(56) References cited:
EP-A- 0 795 898          WO-A-98/43988
DE-A- 19 730 119         US-A- 5 677 002

• **DAHMEN K -H ET AL: "MOCVD OF HIGH-TC SUPERCONDUCTING MATERIALS" PROGRESS IN CRYSTAL GROWTH AND CHARACTERIZATION OF MATERIALS, vol. 27, no. 2, 1 January 1993, pages 117-161, XP000479940**
• **W. CLEGG ET AL: 'X-RAY STRUCTURE OF (Bi(NMe2)3)' INORGANIC CHEMISTRY vol. 30, no. 24, 27 November 1991, US, pages 4680 - 4682, XP002099030**

EP 0 966 553 B1

## Description

This application is related to US-Patent 6,303,391 filed November 17, 1997, entitled "Low Temperature Chemical Vapor Deposition Process for Forming Bismuth-containing Ceramic Films Useful in Ferroelectric Memory Devices."

Background of the Invention

This invention relates to chemical vapor deposition methods for providing a Bi oxide-containing film on a surface of a substrate by decomposing a precursor of Bi oxide.

Interest in ferroelectrics has increased in recent years, due to the utility of these materials in applications such as non-volatile memories. Information in these memories is stored by the polarization of a thin ferroelectric film which is placed between the two plates of a capacitor. The .capacitor is connected to a transistor to form a storage cell, which controls the access of read-out electronics to the capacitor.

The information stored in the cell can be changed by applying an electric field to the thin ferroelectric film and flipping the polarization. Ferroelectric random access memories (FERAMs), unlike DRAMs (dynamic random access memories), retain the stored information if the power supply is turned off. In addition, they do not require refresh cycles. Desirable electrical properties for ferroelectrics used in memory applications include: (a) a low coercive field, which makes the use of as low a voltage supply as possible; (b) a high remanent polarization, which is needed for high reliability of information storage; (c) minimal fatigue, which is required for a long life-time; and (d) no imprint, as an imprint would alter the stored information.

Strontium bismuth tantalate $(SrBi_2Ta_2O_9)$ (SBT) is a ferroelectric material that meets all of these requirements. Significant efforts are therefore being made to integrate this material into memory devices. Capacitors in which SBT is incorporated using a sol-gel method have good electrical properties. The sol-gel method provides only a low integration density of SBT, however. To achieve a higher integration density of SBT, an alternative method, such as chemical vapor deposition (CVD), must be used.

Methods of forming a film comprising Bi oxide on a substrate are known from WO 98 43988 A and DE 197 30119 A, WO 98 43 988 A discloses to decompose a precursor of Bi oxide to form Bi oxide, wherein said precursor of Bi oxide comprises at least one amide group.

Summary of the Invention

In one aspect, the invention features a method of forming a Bi-containing metal oxide film on a substrate; the method includes decomposing a precursor of Bi oxide and depositing the Bi oxide on the substrate. Bi complexes which include at least one amide group are used as the precursors of Bi oxide.

Embodiments of this aspect of the invention may include one or more of the following features.

The precursor of Bi oxide is dissolved in a solution prior to being decomposed. The deposition temperature is above 300°C, and lower than 450°C, and is more preferably lower than 400°C. The Bi oxide-containing film may also be provided by adding the step of decomposing a precursor of Sr oxide and a precursor of Ta oxide to form Sr oxide and Ta oxide, respectively, and depositing the Bi oxide, the Sr oxide and the Ta oxide on the substrate.

The Bi-containing metal oxide film may be deposited as a ferroelectric film or can be converted into a ferroelectric film by an annealing process.

The Bi-containing metal oxide film is formed by placing the substrate in a CVD chamber, heating the substrate to a deposition temperature lower than 450°C, introducing vapors of the precursors of Bi, Sr, and Ta oxides to the CVD chamber, decomposing the precursors of Bi, Sr, and Ta oxides, and depositing the oxides on the substrate. Precursors of Bi, Sr, and Ta oxides may be decomposed in the presence of an oxidizer by oxidative decomposition, where examples of the oxidizers include $O_2$, singlet $O_2$, $O_3$, $H_2O_2$, $N_2O$, $NO_x$ ($1 \leq x \leq 3$), and downstream oxygen plasma, and where the concentration of the oxidizer is between 5% and 95% of the total gas and vapor flow into the CVD chamber. At least one of $O_2$ and $N_2O$ may be used as the oxidizer. The oxidizer may be formed in the CVD chamber by converting an oxidizer molecule into an active oxidizer by applying to the CVD chamber plasma, UV light, heat, a sensitizer, or ion beams.

The precursor of Bi oxide may have the formula $Bi(NR_2)_3$, $Bi(NR_2)_2(L)$, where L is NR", alcoxyamine, alkylene diamine, or β-ketoamidate, or $Bi(NRR')_3$, where each of R, R', and R" is, independently, an alkyl group, an aryl group, or a silyl group. For example, each of R and R' may be, independently, $^tpentyl$, pentyl, $^tBu$, Bu, $^iPr$, Pr, Et, Me, Ph, aryl, or $SiR'''_3$, and R''' may be $^tBu$, Bu, $^iPr$, Pr, Et, or Me. Examples of precursors of Bi oxide include $Bi(NMe_2)_3$ and $Bi(NEt_2)_3$. The precursor of Bi oxide may also include an alkoxy group, or a donor atom such as N, O, or S; for example, the precursor may include the group $-CH_2CH_2-N(CH_3)_2$.

The Bi-containing metal oxide deposited on the substrate may have the formula $(Bi_2O_2)^{2+}$ $(A_{m-1}B_mO_{3m+1})^{2-}$, where A is $Bi^{3+}$, $L^{3+}$, $L^{2+}$, $Ca^{2+}$, $Sr^{2+}$, $Ba^{2+}$, $Pb^{2+}$, or $Na^+$, B is $Fe^{3+}$, $Al^{3+}$, $Sc^{3+}$, $Y^{3+}$, $L^{3+}$, $L^{4+}$, $Ti^{4+}$, $Nb^{5+}$, $Ta^{5+}$, $W^{6+}$, or $Mo^{6+}$, and L is $Ce^{4+}$, $La^{3+}$, $Pr^{3+}$, $Ho^{3+}$, $Eu^{2+}$, or $Yb^{2+}$, and where $1 \leq m \leq 5$. The Bi-containing metal oxide may also have the formula $Bi_2WO_6$; $BiMO_3$, where M is Fe or Mn; $Ba_2BiMO_6$, where M is V, Nb or Ta; $Pb_2BiMO_6$, where M is V, Nb or Ta; $Ba_3Bi_2MO_9$, where M is Mo or W; $Pb_3Bi_2MO_9$, where M is Mo or W; $Ba_6BiMO_{18}$, where M is Mo or W; $Pb_6BiMO_{18}$, where M

is Mo or W; $KBiTi_2O_6$; or $K_2BiNb_5O_{15}$. These metal oxides can be obtained by decomposing precursors which contain the above-described metals.

The Bi-containing metal oxide film can also be a SBT derivative. Examples of such derivatives include $SrBi_2Ta_2O_9$; $SrBi_2Ta_{2-x}Nb_xO_9$, where $0 \leq x \leq 2$; $SrBi_2Nb_2O_9$; $Sr_{1-x}Ba_xBi_2Ta_{2-y}Nb_yO_9$, where $0 \leq x \leq 1$ and $0 \leq y \leq 2$; $Sr_{1-x}Ca_xBi_2Ta_{2-y}Nb_yO_9$ where $0 \leq x \leq 1$ and $0 \leq y \leq 2$; $Sr_{1-x}Pb_xBi_2Ta_{2-y}Nb_yO_9$, where $0 \leq x \leq 1$ and $0 \leq y \leq 2$; or $Sr_{1-x-y-z}Ba_xCa_yPb_zBi_2Ta_{2-p}Nb_pO_9$, where $0 \leq x \leq 1$, $0 \leq y \leq 1$, $0 \leq z \leq 1$, and $0 \leq p \leq 2$. An element of the metal oxide may be substituted by a metal such as Ce, La, Pr, Ho, Eu, and Yb.

The precursor of Sr oxide generally has the formula $Sr(thd)_2$ or $Sr(thd)_2$ adduct, and may include a polyether or a polyamine. The polyether has the formula $R-O-(CH_2CH_2O)_n-R'$, where $2 \leq n \leq 6$, and where each of R and R' may be, independently, an alkyl group, an aryl group, or hydrogen. The polyamine has the formula $R-NR''-(CH_2CH_2NR'')_n-R'$, where $2 \leq n \leq 6$, where each of R and R' may be, independently, an alkyl group, an aryl group, or hydrogen, and where R'' is H, Me, Et, or Pr. The precursor of Sr oxide may also include tetraglyme, triglyme, N,N,N',N'',N''-pentamethyl-diethylene-triamine, or N,N,N',N'',N''',N'''-hexamethyl-triethylene-tetramine.

The precursor of Ta oxide generally has the formula $Ta(OR)_{5-n}(X)_n$, where R is Me, Et, Pr, $^iPr$, Bu, $^iBu$, $^tBu$, pentyl, or $^i$pentyl, where X is β-diketonate, and where $1 \leq n \leq 5$. For example, the precursor may be $Ta(O^iPr)_4(thd)$.

The precursors of the Bi, Sr, and Ta oxides are dissolved in a solution of an aliphatic, a cycloaliphatic, or an aromatic solvent that may include a functional group such as an alcohol, ether, ester, amine, ketone, or aldehyde group. For example, the precursors of Bi, Sr, and Ta oxides may be dissolved in a solvent such as octane. Alternatively, the precursors may be dissolved in a mixture of THF, $^iPrOH$, and tetraglyme in a ratio of about 8:2:1, respectively, or a mixture of octane, decane, and pentamethyl-diethylene-triamine in a ratio of about 5:4:1. Butyl acetate may be used as the solvent for the precursors of Sr and Ta oxides, and octane for the precursor of Bi oxide.

The solutions containing the precursors are evaporated by vaporizers. For example, the solution containing the precursor of Bi oxide is evaporated at a temperature from 130°C to 300°C, and the solution for the precursors of Sr and Ta oxides is evaporated at a temperature from 170°C to 240°C. An inert gas such as Ar, He, or $N_2$ is added to the vapors of the solution, and a mixture of the inert gas and vapors is delivered to the CVD chamber. For example, the mixture includes vapors of the precursors of Bi oxide, Sr oxide, and Ta oxide in a ratio of about 2:1:2. It is appreciated that the concentrations of the precursors in the vapor mixture depend on several factors including vaporization temperature, pressure in the vaporizer, gas and vapor flow rate, desired film stoichiometry, and geometry of the CVD chamber.

In the CVD chamber, the substrate is heated to the deposition temperature of 300°C to 450°C. The pressure in the CVD chamber is . maintained between $1{,}333 \cdot 10^{-1}$ Pa (0.001 torr) and $1{,}013 \cdot 10^5$ Pa (760 torr), for example, between 0.1 torr and 10 torr. An additional inert gas is added to the CVD chamber, where the concentration of the inert gas may vary from 10% to 90% of the total gas and vapor flow into the CVD chamber, for example, 30% to 50%. Preferably, the vapors of the precursors, the oxidizers, and an inert gas are introduced to the CVD chamber at a total flow rate of 1 ml/min to 15,000 ml/min, measured at the standard condition. The desirable flow rate may also depend on the temperature and pressure of the gas and vapor mixture, desired film stoichiometry, and geometry of the CVD chamber. The oxides are deposited onto the substrate over a time period between 2 minutes and 2 hours, for example, between 2 minutes and 15 minutes. After deposition, the film is heated to a temperature of 600°C to 800°C for a time period between 5 minutes and 3 hours.

The substrate preferably includes Si, n-doped Si, p-doped Si, $SiO_2$, $Si_3N_4$, GaAs, MgO, $Al_2O_3$, $ZrO_2$, $SrTiO_3$, $BaTiO_3$, or $PbTiO_3$. The film of Bi-containing metal oxide is deposited on a bottom electrode disposed on the substrate which includes a transistor. The bottom electrode is connected to the transistor by a plug. The bottom electrode may include a metal such as Pt, Pd, Au, Ir, or Rh; a conducting metal oxide such as $IrO_x$, $RhO_x$, $RuO_x$, $OsO_x$, $ReO_x$, or $WO_x$, where $0 \leq x \leq 2$; a conducting metal nitride such as $TiN_x$, $ZrN_x$, or $WN_yTaN_y$, where $0 \leq x \leq 1.0$ and $0 \leq y \leq 1.7$; or a superconducting oxide such as $YBa_2Cu_3O_{7-x}$ where $0 \leq x \leq 1$, and $Bi_2Sr_2Ca_2Cu_3O_{10}$. The bottom electrode may be a Pt electrode.

A first intermediate layer may be provided between the bottom electrode and the plug. Examples of the first intermediate layer include a Ti adhesion layer and a Ti nitride diffusion barrier layer. A second intermediate layer may also be provided between the bottom electrode and the metal oxide layer. Examples of the second intermediate layer include a seed layer, a conducting layer, and a dielectric layer of high permittivity. The plug may include W or Si, and is connected to the bottom electrode and to a source/drain of a MOS field effect transistor. The film may also be used as a thin ferroelectric film for a ferroelectric capacitor, a ferroelectric memory, and/or a ferroelectric field effect transistor, for example, a metal ferroelectric semiconductor or a metal ferroelectric insulating semiconductor.

The substrate may be flushed with a mixture of an inert gas and the oxidizer before and/or after being exposed to the vapors of the precursors of the metal oxides. The processes of heating, decomposing, and depositing may be performed at least twice on the substrate. The substrate may also be removed from the chamber, treated by at least one intermediate process, such as a rapid thermal process, and returned to the chamber.

The operating conditions of the CVD may also be changed. For example, the compositions of the precursors, oxidizers, and inert gas in the mixture may be varied while the substrate is positioned in the chamber. Deposition temperature as well as the chamber pressure may also be varied. The precursor of Bi oxide may be delivered to the CVD chamber during a period between the onset of deposition and 30 minutes thereafter; the concentration of the Bi oxide is then decreased. In other methods, the substrate may be heated inside the chamber at a temperature lower than 450°C at least twice, or the substrate may be heated inside the chamber at a temperature lower than 450°C in the presence of at least one of the oxidizers $O_2$ and $O_3$.

In another aspect, the invention features a method of forming a metal oxide film on a substrate, by heating the substrate to a temperature lower than 450°C and introducing vapors of a precursor of Bi oxide to the substrate. Bi complexes which include at least one amide group are used as the precursors of Bi oxide. The precursor of Bi oxide decomposes at the surface of the substrate to form Bi oxide, which is deposited on the surface of the substrate.

As used herein, the term "precursor of Bi oxide" means any Bi complex which may be degraded to form Bi oxide. Examples of precursors of Bi oxide include Bi amides, which have the structure $Bi(NR_2)_3$, $Bi(NRR')_3$, or $Bi(NR_2)_2(L)$ where L is NR", alcoxyamine, alkylene diamine, or $\beta$-ketoamidate, where each of R, R', and R" is, independently, an alkyl or aryl group. Bi amides also include derivatives of the above-described precursors.

The use of Bi amides as the precursors of Bi oxide in chemical vapor deposition offers numerous advantages. Bi amides contain Bi-N bonds which are relatively easy to cleave. Accordingly, Bi amides can be decomposed at relatively low temperatures. Decomposition and deposition at a lower temperature decreases the migration of Bi oxide to the bottom electrode and the substrate. The degradation of the pre-existing structure is thereby minimized.

Other features and advantages of the invention will be apparent from the following detailed description, and from the claims.

Brief Description of the Drawing

Fig. 1 is a schematic diagram of a storage cell with a ferroelectric memory:
Fig. 2 is a schematic diagram of a SBT layer incorporated into a stack capacitor with a transistor.
Fig. 3 is a graph showing the STA results of Bi $(NMe_2)_3$ in Ar (left) and $O_2$ (right).
Fig. 4 is a graph showing the XRD results of $\alpha$-$Bi_2O_3$

from oxidation of $Bi(NMe_2)_3$ after heating to 500°C.
Fig. 5 is a graph showing the STA results of Bi $(NPh_2)_3$ in Ar (left) and $O_2$ (right).
Fig. 6 is a graph showing the STA results of $Bi(N(SiMe_3)_2)_3$ in Ar (left) and $O_2$ (right).
Fig. 7 is a graph comparing the powder XRD of the oxidation product of $Bi(N(SiMe_3)_2)_3$ to $Bi_{12}O_{20}Si$.
Fig. 8 is a graph showing the EDS results of the oxidation product of $Bi(N(SiMe_3)_2)_3$.

Detailed Description

Chemical vapor deposition can be used to provide a thin film of Bi, Sr, and Ta oxides on a surface of a substrate. The substrate can then be used to manufacture devices such as storage cells.

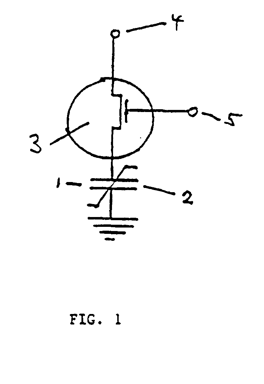

Referring to Fig. 1, a storage cell is formed by placing a layer **1** of ferroelectric material between two plates of a capacitor **2**. Capacitor **2** is connected to transistor **3** which has a bit-line **4** and a word-line **5,** and which controls access of read-out electronics to capacitor **2.** Ferroelectric layer **1** stores information by polarization in a non-volatile manner.

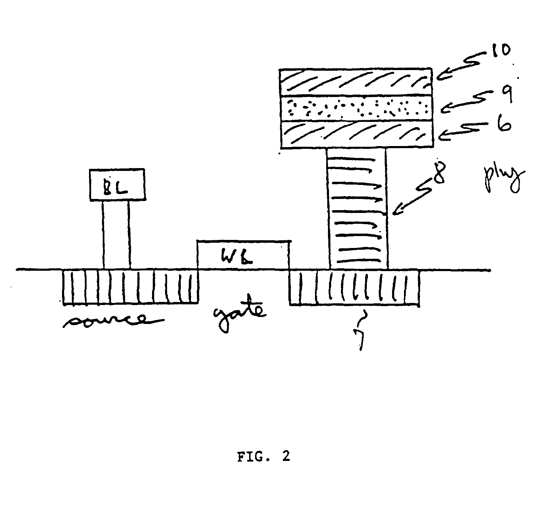

Referring to Fig. 2, a ferroelectric SBT layer **9** is incorporated into a stack capacitor with a transistor to form a storage cell. The stack capacitor sits on top of the transistor, and the bottom electrode **6** of the capacitor is connected with a drain of the MOSFET (metal-oxide-semiconductor-field-effect-transistor) by a plug **8** which is made from either poly Si or W. Ferroelectric layer **9** is disposed between the bottom electrode **6** and the top electrode **10**.

Chemical vapor deposition (CVD) is used to provide the ferroelectric layers in Figs. 1 and 2. For example, CVD is used to deposit layers of metal oxides of Bi, Sr, and Ta on a $Pt/Ti/SiO_2/Si$ substrate. During CVD, a substrate is placed in a CVD chamber at a low pressure, and is heated to a deposition temperature. Precursors are vaporized and then delivered to the CVD chamber. Vapors of the precursors are decomposed at the surface of the substrate, and metal oxide molecules are deposited on the substrate to form a thin film. Metal oxide films formed by the CVD process have higher conformality and better step coverage than films produced by other methods. Further advantages of the CVD process include high film uniformity, high film density, the capability to grow very thin films, a high throughput, and low manufacturing costs.

**PRECURSORS FOR BI OXIDES**

Bi amides contain Bi-N bonds which are weak enough to undergo decomposition to form Bi oxides at relatively low temperatures. It is believed that the cleavage of these weak Bi-N bonds results in the favorable decomposition mechanism of Bi amides, and subsequent low-temperature deposition of Bi oxides. For example, Bi oxides can be deposited at low temperatures, for example, below 400°C.

The use of Bi amides as precursors of Bi oxides presents an opportunity to produce Bi oxides at relatively low temperatures. The formation of Bi oxide from Bi amides requires $O_2$ during decomposition at the heated substrate. Therefore, the gas phase formation of particles may be controlled by varying the pressure of the oxidizer and by varying the mixing pattern of the vapors and the inert gas in the CVD chamber.

The SBT film obtained using Bi amide as a precursor of Bi oxide exhibits high uniformity of composition within the wafer, high conformity to the structure of the surface, and high run-to-run repeatability. The film of Bi, Sr, and Ta oxides formed by the low temperature deposition is generally non-ferroelectric but can be transformed, by a post-deposition treatment such as annealing, into a ferroelectric Aurivilius phase.

Bi amides used as precursors of Bi oxides generally have the structure $Bi(NR_2)_3$, $Bi(NR_2)_2(L)$, or $Bi(NRR')_3$, where each of R and R' is, independently, $^t$pentyl, pentyl, $^t$Bu, Bu, $^i$Pr, Pr, Et, Me, Ph, aryl, or $SiR''_3$, and where R" is $^t$Bu, Bu, $^i$Pr, Pr, Et, or Me. Examples of Bi amides include $Bi(NMe_2)_3$, $Bi(NMeEt)_3$, and $Bi(NEt_2)_3$.

Bi amides also include derivatives of the precursors discussed above. They also include derivatives in which the R groups are substituted with donor atoms, such as N, O, or S. For example, a $-CH_2CH_2-N(CH_3)_2$ group may be incorporated into a Bi amide to provide the precursor, $Bi(N-CH_2CH_2-N(CH_3)_2)_3$.

All of these molecules are capable of undergoing oxidative decomposition at very low temperatures. Accordingly, these molecules yield Bi oxides in a controlled and reproducible manner. Additional information regarding the preparation of these precursors may be found in one or more of the following references. A.P. Pisarevskii et al., Inorg. Chem. 35(6), p.84 (1990); W.A. Hermann et al., Chem. Ber. 126, p.1127 (1993); R.G. Goel et al., J. Organomet. Chem. 36, p.323 (1972);

## BI-CONTAINING METAL OXIDES

Bi-containing metal oxides deposited on the substrate generally have the following structure:

$$(Bi_2O_2)^{2+}(A_{m-1}B_mO_{3m+1})^{2-},$$

where A is $Bi^{3+}$, $L^{3+}$, $L^{2+}$, $Ca^{2+}$, $Sr^{2+}$, $Ba^{2+}$, $Pb^{2+}$, or $Na^+$, B is $Fe^{3+}$, $Al^{3+}$, $Sc^{3+}$, $Y^{3+}$, $L^{3+}$, $L^{4+}$, $Ti^{4+}$, $Nb^{5+}$, $Ta^{5+}$, $W^{6+}$, or $Mo^{6+}$, where L represents a metal from the lanthanide series, such as $Ce^{4+}$, $La^{3+}$, $Pr^{3+}$, $Ho^{3+}$, $Eu^{2+}$, or $Yb^{2+}$, and m is 1, 2, 3, 4, or 5. These Bi-containing metal oxides are predominantly non-ferroelectric, but can be transformed by an annealing process into ferroelectric oxides with a layered perovskite structure such as the one in the Aurivilius phase. Examples of Bi-containing metal oxides further include:

$Bi_2WO_6$;
$BiMO_3$, where M is Fe or Mn;
$Ba_2BiMO_6$, where M is V, Nb or Ta;
$Pb_2BiMO_6$, where M is V, Nb or Ta;
$Ba_3Bi_2MO_9$, where M is Mo or W;
$Pb_3Bi_2MO_9$, where M is Mo or W;
$Ba_6BiMO_{18}$, where M is Mo or W;
$Pb_6BiMO_{18}$, where M is Mo or W;
$KBiTi_2O_6$; and
$K_2BiNb_5O_{15}$.

Additional information regarding the preparation of these metal oxides may be found in one or both of the following references. T. Kodas and M.J. Hampden-Smith, The Chemistry of Metal CVD, Wiley (1994), and W.S. Rees, CVD of Nonmetals, Wiley (1996).

## PRECURSORS FOR SR OXIDES

$Sr(thd)_2$ or $Sr(thd)_2(tetraglyme)$ is generally used as the precursor of Sr oxide, where thd represents 2,2,6,6,-tetramethyl-heptane-2,5-dionate. Additional ligands of the adduct may be:

polyethers, for example, $R-O-(CH_2CH_2O)_n-R'$, where $2 \leq n \leq 6$, and where each of R and R' is, independently, an alkyl group, an aryl group, or hydrogen; or

polyamines, for example, $RNR''-(CH_2CH_2NR'')_n-R'$, where $2 \leq n \leq 6$, where each of R and R' is, independently, alkyl, aryl, or hydrogen, and where R" is H, Me, Et or Pr.

$Sr(thd)_2$ adducts may include adducts with tetraglyme $(MeO-(CH_2CH_2O)_4-Me)$, triglyme $(MeO-(CH_2CH_2O)_3-Me)$, N,N,N',N",N"-pentamethyldiethylene-triamine $(Me_2N-(CH_2CH_2NMe)_2-Me)$, or N,N,N',N",N'",N'''-hexamethyltriethylene-tetramine $(Me_2N-(CH_2CH_2NMe)_3-Me)$.

## PRECURSORS FOR TA OXIDES

The precursor of Ta oxide generally has the structure $Ta(OR)_{5-n}(X)_n$, where R is Me, Et, Pr, $^i$Pr, Bu, $^i$Bu, $^t$Bu, pentyl, or $^i$pentyl, where X is β-diketonate, and where $1 \leq n \leq 5$. For example, $Ta(O^iPr)_4(thd)$ may be used as the precursor of Ta oxide.

## SBT

Strontium bismuth tantalates generally have the structure $SrBi_2Ta_2O_9$, or one of its derivatives, such as:

$SrBi_2Ta_{2-x}Nb_xO_9$, where $0 \leq x \leq 2$;
$SrBi_2Nb_2O_9$;
$Sr_{1-x}Ba_xBi_2Ta_{2-y}Nb_yO_9$, where $0 \leq x \leq 1$ and $0 \leq y \leq 2$;
$Sr_{1-x}Ca_xBi_2Ta_{2-y}Nb_yO_9$ where $0 \leq x \leq 1$ and $0 \leq y \leq 2$;
$Sr_{1-x}Pb_xBi_2Ta_{2-y}Nb_yO_9$, where $0 \leq x \leq 1$ and $0 \leq y \leq 2$;
$Sr_{1-x-y-z}Ba_xCa_yPb_zBi_2Ta_{2-p}Nb_pO_9$, where $0 \leq x \leq 1$, $0 \leq y \leq 1$, $0 \leq z \leq 1$, and $0 \leq p \leq 2$.

SBT's also include the above described compounds in which one or more elements are substituted and/or doped by a metal from the lanthanide series, such as Ce, La, Pr, Ho, Eu, and Yb.

## SOLUTION MIXTURES

Preferably, liquid delivery CVD is used in the methods of the invention. During liquid delivery CVD, precursors of Bi, Sr, and Ta oxides are dissolved in a solvent or a mixed solution and are then delivered to a vaporizer in a liquid phase. Examples of solvents include, but are not limited to, aliphatic, cycloaliphatic or aromatic solvents, which may have functional groups such as alcohols, ethers, esters, amines, ketones, and/or aldehydes. Mixture of these solvents may also be used, for example, a mixture of THF, $^i$PrOH, and tetraglyme in a ratio of 8:2:1, respectively, and a mixture of octane, decane, and pentamethyl-diethylene-triamine in a ratio of about 5:4:1.

Under some conditions, Bi amides can show a rapid ligand exchange with $Sr(thd)_2$ and $Ta(O^iPr)_4(thd)$. The ligand exchange is not degenerative, but may result in the formation of a poorly characterized mixture of mixed ligand alcoxides and $\beta$-diketonate coordinated metal complexes. This exchange can occur at both room temperature and elevated temperatures. The formation of poorly defined mixtures may lead to poor flash vaporization and uncontrolled gas-phase concentrations of the reactants. In addition, storage of the precursor solutions becomes more difficult. If ligand exchange of the precursors is observed, precursors having the same ligand can be used. Alternatively, precursors can be stored in separate solutions which are evaporated in separate vaporizers. Further details are described in a currently pending patent application U.S.S.N. 09/107,861, filed June 30, 1998, entitled "Amorphously deposited metal oxide ceramic films," which is hereby incorporated by reference.

## VAPORIZATION PROCESS

Precursors of Bi, Sr, and Ta oxides are vaporized prior to the delivery of these oxides to a CVD chamber. Preferably, the precursor of Bi oxide is evaporated separately from the precursors of Sr and Ta oxides. Accordingly, vaporization of the precursors requires at least two flash vaporizers.

Several delivery approaches may be taken in the multiple vaporizer approach. The precursors are stored in separate solutions, each of which is evaporated in a separate vaporizer. The vapors are then mixed and delivered to the substrate surface in the CVD chamber. Alternatively, precursors of Sr and Ta oxides are stored in separate solutions which are mixed prior to vaporization, for example, by a liquid delivery system. The mixed solution is delivered to a single vaporizer. The precursor of Bi oxide is delivered to a second vaporizer.

After evaporating the precursors, the vapors are mixed and delivered to the CVD chamber.

In yet another process, precursors of Sr and Ta oxides are stored as a precursor mixture in one solution and delivered to a single vaporizer. Bi amide is delivered to a second vaporizer. After evaporation of the precursors, the vapors are mixed and delivered to the CVD chamber. Alternatively, Bi amide may be vaporized in one vaporizer and precursors of Sr and Ta oxides in a second vaporizer. However, instead of having precursors of Sr and Ta oxides in two separate reservoirs, two solution mixtures are prepared where each contains precursors of Sr and Ta oxides in different concentrations. This allows more accurate mixing of the precursors of Sr and Ta oxides. Additional information regarding the CVD process may be found in one or more of the following references. U.S. Pat. Application U.S.S.N. 08/758,599, filed November 27, 1996, entitled "Multiple Vaporizer Reagent Supply System for Chemical Vapor Deposition Utilizing Dissimilar Precursor Composition"; U.S. Pat. No. 5,536,323; U.S. Pat. No. 5,337,651; U.S. Pat. No. 5,431,957; U.S. Pat. No. 5,362,328; and U.S. Pat. No. 5,204,314.

## OXIDIZER

Precursors of Bi, Sr, and Ta oxides are decomposed in the presence of an oxidizer by oxidative decomposition. $O_2$ is generally used as an oxidizer. However, deposition efficiency may be improved by using more reactive oxidizers during the film deposition. Examples of these alternate oxidizers include singlet $O_2$, $O_3$, $H_2O_2$, $N_2O$, $NO_x$ ($1 \leq x \leq 3$), and downstream oxygen plasma.

The concentration of the oxidizer may be maintained at a level between 5% and 95% of the total gas and vapor flow into the CVD chamber. At least one of $O_2$ and $N_2O$ may be used as the oxidizer. The oxidizer may be supplied to the CVD chamber from an external source such as a tank, bottle, reservoir, or generator, or may be formed in the CVD chamber by converting a molecule therein into an active oxidizer by applying to the CVD chamber plasma, UV light, heat, a sensitizer, or ion beams.

$O_3$ can form oxygen radicals $O^-$ which can react with the precursors of Bi oxide, Sr oxide, and/or Ta oxide. The reaction may occur in the boundary layer, for example, by inserting the $O^-$ radical into the Bi-N bonds or by undergoing an electrocyclical bimolecular reaction. When $O_3$ reacts with a precursor containing a phenyl ring, $O_3$ may attack the ring and crack the molecule from another side, yielding an intermediate product such as $O=BiPh_3$, which may either decompose back to $BiPh_3$ or undergo a rearrangement to form a $(PhO)BiPh_2$. Chemical properties of the substrate surface may also be affected by $O_3$. For example, the amount of adsorbed O atoms may be increased, or the electrochemical potential of the surface and its electrical conductivity

may be altered. $O_3$ may also affect the chemical properties of the surface of the Bi-containing metal oxide film during its growth in the CVD chamber.

NO and $NO_2$ can react with the precursors already in the boundary layer. In addition, NO and $NO_2$ can be adsorbed on the substrate, react with intermediate products from the decomposition reaction of the precursors, or increase the substrate surface potential for further chemical reactions.

$H_2O_2$ can react with the precursors in the boundary layer or at the heterogenous surface. $H_2O_2$ may form OH and OOH groups on the substrate and provide new decomposition pathways for the precursors.

Singlet $O_2$ ($^1O_2$) is a very effective oxidizer which can be formed by light irradiation of triplet $^3O_2$ in the presence of a sensitizer such as rose bengal or via direct irradiation of $^3O_2$ below 200 nm by, for example, a low pressure Hg lamp/excimer laser.

To form downstream oxygen plasma, the precursor vapor is mixed with an oxygen plasma. The reactive species in the plasma are single O atoms, activated $O_2$ molecules, and $O_3$. The plasma is generated before the oxidizer is mixed with the precursor vapor. This technique effectively modifies CVD processes without direct exposure of the precursors to the high translational energies present in the plasma. G. Lucovsky et al., J. Vac. Sci. Tech. A 4, 681, [1986]; Van Buskirk et al., J. Vac. Sci. Tech. A 10(4), 1578, [1992].

The use of oxidizers offers a number of benefits in depositing the Bi-containing metal oxide film. In general, oxidizers allow low temperature deposition of Bi oxides on the substrate. Oxidizers also stabilize and enhance the deposition of Bi oxides at low pressures. Oxidizers also help in depositing the Bi-containing metal oxide film in a desirable phase.

**CVD PROCESS**

The substrate is heated to a deposition temperature ranging from 300°C to 500°C. Preferably, the substrate is heated to a temperature below 450°C. The pressure in the chamber is maintained between 0.1 and 10 torr. A carrier gas such as Ar, He, or $N_2$, and oxidizers such as $O_2$, singlet $O_2$, $O_3$, $N_2O$, $NO_x$ ($1 \leq x \leq 3$), and downstream oxygen plasma are also delivered to the CVD chamber. The total gas flow is maintained between $1,69 \cdot 10^{-3}$ and $2,535 \cdot 10^1$ Pa·m³/s (1 and 15,000 sccm), where sccm represents a volumetric flow rate in the unit of cc/min measured at the standard condition, that is, at 0°C and 1 atm. The deposition time ranges from 30 to 60 minutes.

CVD processes for SBT can be carried out at different deposition temperatures. For example, the CVD process at a temperature such as 430°C yields a non-ferroelectric film in the fluorite phase. By annealing between 600°C and 820°C, for example, at 750°C for one hour, this film is converted into the ferroelectric Aurivilius phase. The structure of the deposited film depends on many different deposition parameters, although the deposition temperature has the most profound effect. For example, films deposited at lower temperatures, for example, at 350°C, are predominately amorphous.

At high temperatures, for example, 650°C, the CVD process yields films which are in a crystalline non-ferroelectric phase, such as a fluorite phase, or which are already in the ferroelectric Aurivilius phase. By annealing at 800°C (ferroanneal), the non-ferroelectric SBT layer can be transformed into the ferroelectric Aurivilius phase, or the electrical properties of the existing ferroelectric films can be enhanced.

Alternatively, the deposition may be carried out under two different conditions. For example, it may be advantageous to deposit more Bi oxides in the beginning of the CVD process than during the rest of the process to compensate for a loss of Bi oxides due to depletion into the bottom electrode during deposition and/or annealing. It may also be helpful to have a nucleation control in the beginning, even if this decreases the growth rate. After the nucleation step, the conditions are changed for a high growth rate in the second deposition step. Nucleation is very important for phase control and can be very important for composition control, for example, if the film composition depends on the nature of the surface.

EXAMPLE 1 TGA AND DSC STUDY RESULTS

STA, a combination of thermogravimetric analysis (TGA) and differential scanning calorimetry (DSC), was performed in both argon and oxygen atmospheres.

Bi amides were monomeric in the vapor phase according to mass spectrometry and were readily vaporized upon mild heating under vacuum. A series of Bi amides were synthesized and purified by distillation, sublimation or crystallization.

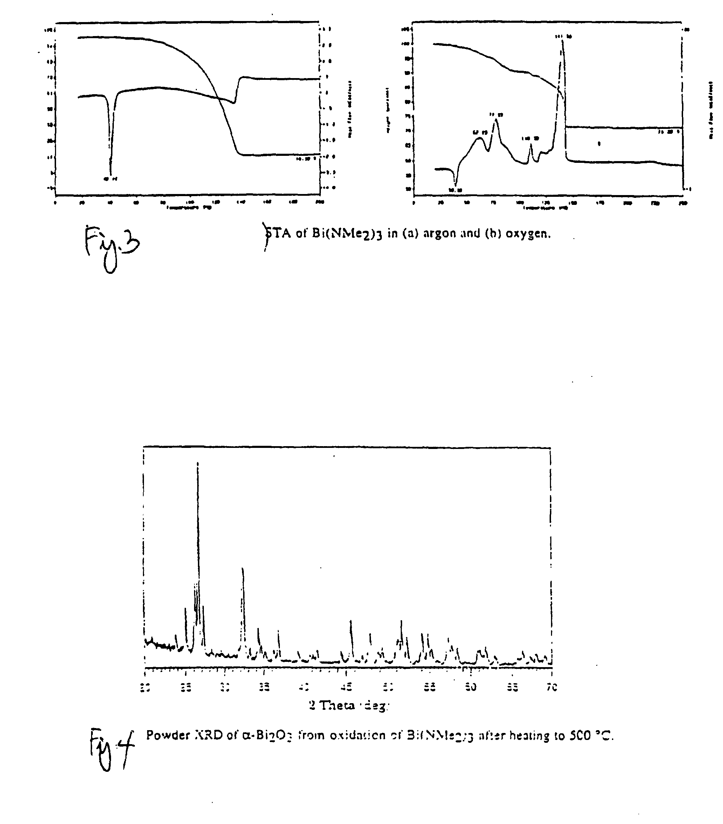

$Bi(NMe_2)_3$ was prepared as reported in the literature. Clegg, W. et al.; X-ray Crystal Structure of [Bi$(NMe_2)_3$], Inorganic Chemistry 1991; **30**(24), pp. 4680-4682. The $^1$H NMR spectrum consisted of a singlet at 3.45 ppm in $C_6D_6$, indicating that all of the methyl groups were equivalent at room temperature. $Bi(NMe_2)_3$ was stable indefinitely when stored at -40°C, under an inert atmosphere, in the dark. However, the material was photolytically, oxidatively, and hydrolytically unstable. The surface of $Bi(NMe_2)_3$ became black upon storage under fluorescent lights, and it smoked upon exposure to air. $Bi(NMe_2)_3$ hydrolyzed readily to form an insoluble white precipitate and free dimethylamine, $NHMe_2$. Fig. 3 shows the STA results of $Bi(NMe_2)_3$ in Ar (left) and $O_2$ (right). In Ar, $Bi(NMe_2)_3$ melted at 40°C followed by sublimation between 60°C and 140°C at atmospheric pressure. In $O_2$, decomposition of $Bi(NMe_2)_3$ began immediately after melting. Multiple exotherms were observed up to 140°C, where the transformation to $Bi_2O_3$ was es-

sentially complete, based upon weight loss. A. small (1%) drop in weight was observed at 425°C (not shown), perhaps due to the annealing of excess carbon from the residue or loss of Bi due to evaporation. As shown in Fig. 4, the powder XRD of material heated to 500°C in $O_2$ revealed the material to be $\alpha$-$Bi_2O_3$.

$Bi(NEt_2)_3$ was prepared as reported in the literature. Clegg, W. et al.; X-ray Crystal Structure of [Bi($NMe_2)_3$], Inorganic Chemistry 1991; **30**(24), pp. 4680-4682. The $^1$H NMR spectrum consisted of a quadruplet at 3.74 ppm and a triplet at 1.14 ppm in $C_6D_6$, indicating that all of the. ethyl groups were equivalent at room temperature. As with the methyl analog, $Bi(NEt_2)_3$ decomposed photolytically to a black insoluble material. $Bi(NEt_2)_3$ was too air sensitive to allow for the acquisition of the STA data.

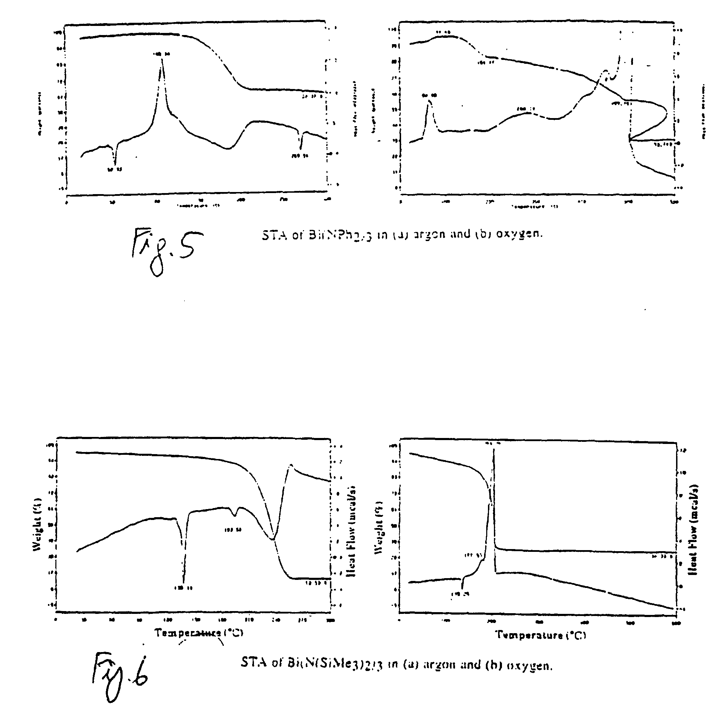

$Bi(NPh_2)_3$ was prepared as reported in the literature and recrystallized. Clegg, W. et al.; X-ray Crystal Structure of [Bi($NMe_2)_3$], Inorganic Chemistry 1991; **30** (24), pp. 4680-4682. The $^1$H NMR spectrum consisted of a multiplet at 7.04 ppm and another at 6.72 ppm in $C_6D_6$, indicating that all of the phenyl groups were equivalent at room temperature. $Bi(NPh_2)_3$ was not photolytically sensitive, but did not hydrolyze readily to form an insoluble precipitate and to free diphenylamine, $NHPh_2$. The X-ray crystal structure of $Bi(NPh_2)_3$ was similar to that of $Bi(NMe_2)_3$. Attempts at sublimation under vacuum were unsuccessful, resulting in decomposition to a black liquid with the evolution of a colorless, volatile material. Fig. 5 shows the STA results of $Bi(NPh_2)_3$ in Ar (left) and $O_2$ (right). In Ar, the STA revealed an endotherm at 53°C followed by a decomposition exotherm at 108°C, and a second endotherm at 270°C. A capillary melting point observation suggested that the first endotherm was due to a solid-solid phase transition, while decomposition/melting occurred between 100°C and 113°C. The endotherm at 270°C was not examined further. The volatile decomposition product sublimed between 120°C and 200°C leaving a 61 wt% residue at 300°C. The byproducts were not identified, but the mass loss did not appear to correspond to biphenyl ($Ph_2$), azobenzene (PhNNPh), or tetraphenylhydrazine ($Ph_2NNPh_2$). In $O_2$, the STA revealed a reaction beginning at 50°C, with a maximum exotherm at ca. 65°C that was associated with the addition of ca. 3-5 wt%. This material decomposed between 125°C and 190°C, losing 14 wt%. A slow decomposition then occurred between 190°C and 490°C accompanied by 20-25 wt% loss. At 500°C, the sample exploded, yielding a large exotherm. The remaining material (residue 34 wt%) corresponded well with the expected amount, if $Bi_2O_3$ (calculated 33 wt%) was formed. The composition of the oxidation product was not identified by the powder XRD.

$Bi(N(SiMe_3)_2)_3$ was prepared as reported in the literature. Clegg, W. et al.; X-ray Crystal Structure of [Bi($NMe_2)_3$], Inorganic Chemistry 1991; **30**(24), pp. 4680-4682. The product was purified by sublimation at 100°C and $1,333 \cdot 10^1$ Pa (100 mtorr.) The $^1$H NMR spectrum consisted of a single resonance at 0.36 ppm in $C_6D_6$, indicating that all of the trimethylsilyl groups were equivalent at room temperature. $Bi(N(SiMe_3)_2)_3$ hydrolyzed readily to form an insoluble precipitate and to free hexamethyldisilazane (NH($SiME_3)_2$), observed at 0.09 ppm in $C_6D_6$. The originally reported melting/decomposition temperature of 90°C. was incorrect.

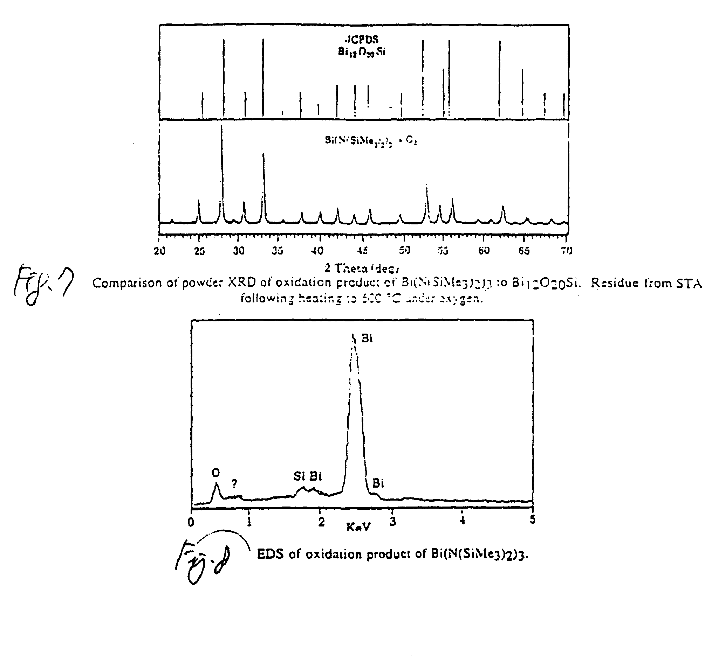

Fig. 6 shows the STA results of $Bi(N(SiMe_3)_2)_3$ in Ar (left) and $O_2$ (right). In Ar, a solid-solid phase transition was observed at 136°C, and $Bi(N(SiMe_3)_2)_3$ melted at 185°C according to the DSC. The melting point was confirmed by capillary melting point measurement. Sublimation occurred between 220°C and 270°C at atmospheric pressure. In $O_2$, decomposition occurred between 150°C and 220°C. The product of the thermal oxidation was examined by powder XRD as shown in Fig. 7. The product was found to be a Bi oxide distinct from $\alpha$-$Bi_2O_3$.

## EXAMPLE 2 LOW-TEMPERATURE CVD PROCESS

A Pt/Ti/$SiO_2$/Si substrate (100 nm Pt on 10 nm Ti) is placed in a CVD chamber. The temperature of the substrate is maintained by a resistivity heater and kept between 300°C and 500°C, for example, 430°C. The chamber pressure is between $6,665 \cdot 10^1$ Pa and $6,665 \cdot 10^2$ Pa (0.5 and 5 torr) for example, $1,333 \cdot 10^2$ Pa (1 torr). The total gas flow is between $8,45 \cdot 10^{-1}$ $\frac{Pa.m^3}{s}$ and $3,38$ $\frac{Pa.m^3}{s}$ (500 and 2,000 sccm) for example, $2,197$ $\frac{Pa.m^3}{s}$ (1,300 sccm). $O_2$ is used as an oxidizer. The amount of $O_2$ is between 20% and 80% of the total gas flow, for example 40%. The deposition time is 30 to 60 min.

$Bi(NMe_2)_3$ (bismuth tris (dimethylamide)), Sr (thd)$_2$ (tetraglyme), and Ta($O^iPr)_4$(thd) are used as precursors of Bi oxide, Sr oxide, and Ta oxide, respectively. Precursors of Sr oxide and Ta oxide are stored in a solution of THF, $^i$PrOH, and tetraglyme in a ratio of 8:2:1, respectively. The concentrations in the solution are 0.3 molar Ta precursor and 0.15 molar Sr precursor. This solution is delivered by a pump to a flash-vaporizer and evaporated on a stainless-steel frit at a temperature between 210°C and 230°C. A precursor solution delivery rate is 0.05-0.30 ml/min, for example, 0.15 ml/min. A carrier. gas such as Ar is also delivered at a rate of 200-800 sccm, for example, 400 sccm. For a frit 1.6 cm in diameter, these flow rates give efficient evaporation results.

In a second approach, $Bi(NMe_2)_3$ is stored separately in a solution of octane. The concentration of Bi amide is, for example, 0.1 molar. This solution is delivered to a second vaporizer which is maintained at a temperature of 200°C. For a stainless steel frit 1.6 cm in diameter, a liquid delivery rate of 0.05-0.30 ml/min, for example, 0.15 ml/min is used, and a carrier gas flow of 200-800 sccm, for example, 400 sccm is used. After vaporization, vapors of the precursors of Sr oxide and Ta oxide are mixed with Bi amide vapors. These vapors are delivered to a CVD chamber through a showerhead in which they are mixed with $O_2$ and with additional Ar in order to adjust total gas flow and $O_2$ content. Gas flow rates are 6,76 $\underline{Pam^3}$ (4000 sccm) of Ar carrier for the precursors of Sr oxide and Ta oxide, $5,07 \cdot 10^{-1}$ $\underline{Pam^3}$ (300 sccm) of Ar carrier for Bi amide, 180 sccm of additional Ar, and $8,45 \cdot 10^{-1}$ $\underline{Pam^3}$ (520 sccm) of $O_2$.

After the CVD process, the film is annealed at 750°C for 60 minutes or at 800°C for 15 minutes to form the ferroelectric Aurivilius phase.

EXAMPLE 3 <u>HIGH-TEMPERATURE CVD PROCESS</u>

Chemical vapor deposition is also carried out at higher temperatures, for example, at 600°C. Precursors and deposition conditions are the same as those used in the low temperature process. The high-temperature process results in a film which was in a non-ferroelectric fluorite phase, in a ferroelectric Aurivilius phase, or in a mixture of these phases.

After the CVD process, the deposited film is annealed at 750°C for 60 minutes or at 800°C for 15 minutes in order to form and/or to completely crystallize the ferroelectric Aurivilius phase.

EXAMPLE 4 <u>MULTI-STEP CVD PROCESS</u>

A multi-step process is also used, where a different deposition condition is applied for the first 2-10 minutes in order to yield a higher Bi content in the parts of the film adjacent to the Pt bottom electrode than in the rest of the film. An increased amount of the precursor of Bi oxide is delivered to the CVD chamber for the first 2-10 minutes, for example, by increasing the liquid delivery rate of the second, Bi amide vaporizer. All other parameters in this step, and all parameters for the second step, are the same as those used in the single-step process.

It is to be understood that while the invention has been described in conjunction with the detailed description thereof, the foregoing description is intended to illustrate and not limit the scope of the invention, which is defined by the scope of the appended claims. Other aspects, advantages, and modifications are within the scope of the following claims.

**Claims**

1. A method of forming a film on a substrate, said method comprising:

   placing said substrate into a CVD-chamber;
   heating said substrate to a temperature above 300°C and below 450°C; and
   introducing vapors of a precursor of Bi oxide to said substrate, wherein said precursor comprises at least one amide group, said precursor decomposing at the surface of said substrate to form Bi oxide, said Bi oxide being deposited on the surface of said substrate.

2. The method of claim 1, wherein said precursor of Bi oxide is dissolved in a solution prior to being decomposed.

3. The method of claim 1, further comprising:

   decomposing a precursor of Sr oxide and a precursor of Ta oxide at a temperature lower than 450°C to form Sr oxide and Ta oxide, respectively; and
   depositing said Sr oxide and said Ta oxide on said substrate at a temperature lower than 450°C.

4. The method of claim 1, further comprising converting said film into a ferroelectric film by an annealing process.

5. The method of claim 1, wherein said film is deposited as a ferroelectric film.

6. The method of claim 3, wherein said method further comprises:

   placing said substrate in a chamber'
   heating said substrate to a deposition temperature lower than 450° C; introducing vapors of said precursor of Bi oxide, said precursor of Sr oxide, and
   said precursor of Ta oxide into said chamber;
   decomposing said precursors of Bi oxide, Sr oxide, and Ta oxide into said oxides thereof; and
   depositing said oxides on said substrate.

7. The method of claim 6, wherein the decomposition of said precursors comprises:

   introducing an oxidizer into said chamber; and
   converting said precursors into said oxides by oxidative decomposition.

8. The method of claim 7, wherein said oxidizer comprises at least one of $O_2$, singlet $O_2$, $O_3$, $H_2O_2$, $N_2O$, $No_x$, where x is 1, 2, or 3, and downstream oxygen plasma.

9. The method of claim 8, wherein said oxidizer occupies between 5% and 95% of the total gas and vapor flow into said chamber.

10. The method of claim 7, wherein at least two different oxidizers are introduced into said chamber.

**11.** The method of claim 8, wherein said oxidizer comprises at least one of $O_2$ and $N_2O$.

**12.** The method of claim 7, wherein said oxidizer is formed by converting a molecule in said chamber into an active oxidizer by applying at least one of a plasma, UV light, heat, a sensitizer, and ion beams.

**13.** The method of claim 1, wherein said precursor of Bi oxide has the formula $Bi(NR_2)_3$, $Bi(NR_2)_2(L)$, or $Bi(NRR')_3$, wherein L is NR", alcoxyamine, alkylene diamine, or P-ketoamidate, and wherein each of R, R', and R" is, independently, an alkyl group or an aryl group.

**14.** The method of claim 13, wherein said precursor of Bi oxide is $Bi(NR_2)_3$, wherein R is tpentyl, pentyl, tBu, Bu, 'Pr, Pr, Et, Me, Ph, aryl, or $SiR"_3$, and wherein R" is tBu, Bu, 'Pr, Pr, Et, or Me.

**15.** The method of claim 1, wherein said precursor of Bi oxide comprises a donor atom selected from the group consisting of N, O, and S.

**16.** The method of claim 1, wherein said film comprises at least one of Ca, Ba, Pb, Na, Fe, Al, Sc, Y, Ti, Nb, W, Mo, Ce, La, Pr, Ho, Eu, and Yb.

**17.** The method of claim 16, wherein said film comprises a compound having the formula $(Bi_2O_2)^{2+}$ $(A_{m-1}B_mO_{3m+1})^{2-}$ wherein A is $Bi^{3+}$, $L^{3+}$, $L^{2+}$, $Ca^{2+}$, $Sr^{2+}$, $Ba^{2+}$, $Pb^{2+}$ or $Na^+$. B is $Fe^{3+}$, $Al^{3+}$, $Sc^{3+}$, $Y^{3+}$, $L^{3+}$, $L^{4+}$, $Ti^{4+}$, $Nb^{5+}$, $Ta^{5+}$, $W^{6+}$, or $Mo^{6+}$, wherein L is selected from the group consisting of $Ce^{4+}$, $La^{2+}$, $Pr^{3+}$, $Ho^{3+}$, $Eu^{2+}$, and $Yb^{2+}$, and m is 1, 2, 3, 4, or 5.

**18.** The method of claim 1, wherein said film comprises a compound selected from the group consisting of:

$Bi_2WO_6$;
$BiMO_3$, where M is Fe or Mn;
$Ba_2BiMO_6$, where M is V, Nb or Ta;
$Pb_2BiMO_6$, where M is V, Nb or Ta;
$Ba_3Bi_2MO_9$, where M is Mo or W;
$Pb_3Bi_2MO_9$, where M is Mo or W;
$Ba_6BiMO_{18}$, where M is Mo or W;
$Pb_6BiMO_{18}$, where M is Mo or W;
$KBiTi_2O_6$; and
$K_2BiNb_5O_{15}$.

**19.** The method of claim 3, wherein said film comprises a compound selected from the group consisting of:
$SrBi_2Ta_2O_9$; $SrBi_2Ta_{2-x}Nb_xO_9$, wherein $0 \le x \le 2$;

$SrBi_2Nb_2O_9$;
$Sr_{1-x}Ba_xBi_2Ta_{2-y}Nb_yO_9$; wherein $0 \le x \le 1$ and $0 \le y \le 2$;
$Sr_{1-x}$-$Ca_xBi_2Ta_{2-y}Nb_yO_9$ wherein $0 \le x \le 1$ and

$0 \le y \le 2$;
$Sr_{1-x}Pb_xBi_2Ta_{2-y}Nb_yO_9$, wherein $0 \le x \le 1$ and $0 \le y \le 2$ and
$Sr_{1-x-y-z}Ba_xCa_yPb_zBi_2Ta_{2-p}Nb_pO_9$, wherein $0 \le x \le 1$, $0 \le y \le 1$; $0 \le z \le 1$ and $0 \le p \le 2$.

**20.** The method of claim 19, wherein at least one element of said compound is substituted by a metal selected from the group consisting of Ce, La, Pr, Ho, Eu, and Yb.

**21.** The method of claim 3, wherein said precursor of Sr oxide is $Sr(thd)_2$ or $Sr(thd)_2$ adduct.

**22.** The method of claim 21, wherein said precursor of Sr oxide comprises at least one of a polyether and a polyamine.

**23.** The method of claim 22, wherein said polyether has the formula $R$-$O$-$(CH_2CH_2O)_n$-$R'$ wherein $2 \le n \le 6$ and wherein each of R and R' is, independently, an alkyl group, an aryl group, or hydrogen.

**24.** The method of claim 22, wherein said polyamine has the formula $R$-$NR"$-$(CH_2CH_2NR")$-$R'$, wherein $2 \le n \le 6$, wherein each of R and R' is, independently, an alkyl group, an aryl group, or hydrogen, and wherein R" is H, Me, Et or Pr.

**25.** The method of claim 22, wherein said precursor of Sr oxide comprises at least one of tetraglyme, triglyme, N,N,N',N",N"-pentamethyldiethylene-triamine, and N, N, N', N", N"', N"'-hexamethyl-triethylene-tetramine.

**26.** The method of claim 3, wherein said precursor of Ta oxide has the formula $Ta(OR)_{5-n}(x)_n$, wherein R is Me, Et, Pr, 'Pr, Bu, 'Bu, tBu, pentyl, or 'pentyl, wherein X is ss-diketonate, and wherein n is 1, 2, 3, 4, or 5.

**27.** The method of claim 26, wherein said precursor of Ta oxide is $Ta(O'Pr)_4(thd)$.

**28.** The method of claim 3, wherein at least one of said precursors is dissolved in a solution comprising at least one of an aliphatic, cycloaliphatic, and an aromatic solvent,
said solvent having at least one functional group selected from the group consisting of an alcohol, ether, ester, amine, ketone, and aldehyde group.

**29.** The method of claim 28, wherein said precursors of Sr oxide and Ta oxide are dissolved in a mixture of THE, 'PrO H, and tetraglyme in a ratio of about 8:2:1, respectively.

**30.** The method of claim 28, wherein said precursors of Sr oxide and Ta oxide are dissolved in a mixture of octane, decane, and pentamethyldiethylene-triamine in a ratio of about 5:4:1, respectively.

31. The method of claim 28, wherein said precursors of Sr oxide and Ta oxide are dissolved in butylacetate.

32. The method of claim 28, wherein said precursor of Bi oxide is dissolved in octane.

33. The method of claim 28, wherein said solution is evaporated by at least one vaporizer.

34. The method of claim 33, wherein an inert gas is added to the vapors of said solution and a mixture of said inert gas and vapors is delivered to said chamber, said inert gas comprising at least one of Ar, He, and $N_2$.

35. The method of claim 34, wherein said mixture comprises vapors of said precursors of Bi oxide, Sr oxide, and Ta oxide in a ratio of about 2:1:2.

36. The method of claim 6, wherein the pressure in said chamber is between 0.1333 and $1,013 \cdot 10^3$ Pa (0.001-760 torr).

37. The method of claim 36, wherein the pressure in said chamber is between 13.33 and $1,333 \cdot 10^3$ Pa (0,1 - 10 torr).

38. The method of claim 7, wherein an additional inert gas is added to said chamber, said inert gas comprising at least one of Ar, He, and $N_2$, and wherein said additional inert gas occupies between 10% and 90% of the total gas and vapor flow into said chamber.

39. The method of claim 3, wherein said oxides are deposited onto said substrate over a time period between 2 minutes and 2 hours.

40. The method of claim 39, wherein said oxides are deposited onto said substrate over a time period between 2 minutes and 15 minutes.

41. The method of claim 4, wherein said film is heated to a temperature between 600°C and 800°C for a time period between 5 minutes and 3 hours.

42. The method of claim 33, wherein vapors consisting essentially of said precursor of Bi oxide are delivered to said chamber during a period between the onset of deposition and 30 minutes thereafter.

43. The method of claim 1, wherein said substrate comprises at least one of Si, n-doped Si, p-doped Si, $SiO_2$, $Si_3N_4$, GaAs, MgO, $Al_2O_3$, $ZrO_2$, $SrTiO_3$,

$BaTiO_3$, and $PbTiO_3$.

44. The method of claim 1, wherein said film is deposited on a bottom electrode disposed on said substrate,

   said substrate comprising a transistor therein, said bottom electrode being connected to said transistor by a plug.

45. The method of claim 44, wherein said bottom electrode comprises at least one of:

   a metal selected from the group consisting of Pt, Pd, Au, Ir, and Rh;
   a conducting metal oxide selected from the group consisting of IrOx,
   RhOx, RuOx, OSOx, ReOx, WOx, wherein x is 0,1 or 2;
   a conducting metal nitride selected from the group consisting of TINY,
   ZrNx, and WNyTaNy, wherein $0 \leq x \leq 1.0$ and $0 \leq y \leq 1.7$; and
   a superconducting oxide selected from the group consisting of $YBa_2Cu_3O_{7-x}$ where $0 \leq x \leq 1$ and $Bi_2SnCa_2Cu_3O_{10}$.

46. The method of claim 44, wherein said bottom electrode is a Pt electrode.

47. The method of claim 44, wherein at least one first intermediate layer is provided between said bottom electrode and said plug, said first intermediate layer comprising at least one of an adhesion layer and a diffusion barrier layer.

48. The method of claim 44, wherein at least one second intermediate layer is provided between said bottom electrode and said metal oxide film, said second intermediate layer comprising at least one of a seed layer, a conducting layer, and a dielectric layer.

49. The method of claim 44, wherein said plug is connected to said bottom electrode and to a drain of a MOS ferroelectric effect transistor, said plug consisting essentially of W or Si.

50. The method of claim 44, wherein said film is used as a thin ferroelectric film for a ferroelectric capacitor.

51. The method of claim 44, wherein said film is used as a thin ferroelectric film for a ferroelectric memory.

52. The method of claim 51, wherein said film is used as a thin ferroelectric film for a ferroelectric field effect transistor.

**53.** The method of claim 7, wherein said substrate is flushed with a mixture of an inert gas and said oxidizer before being exposed to said vapors of said precursors of said metal oxides.

**54.** The method of claim 7, wherein said substrate is flushed with a mixture of an inert gas and said oxidizer after being exposed to said vapors of said precursors.

**55.** The method of claim 6, wherein at least one of said processes of heating, decomposing and depositing is performed at least twice on said substrate.

**56.** The method of claim 7, wherein said substrate is removed from said chamber, treated by at least one intermediate process, and returned to said chamber.

**57.** The method of claim 28, wherein the composition of said precursors in said mixture is varied while said substrate is positioned in said chamber.

**58.** The method of claim 26, wherein the composition of said inert gas in said mixture is varied while said substrate is positioned in said chamber.

**59.** The method of claim 7, wherein the composition of said oxidizer is varied while said substrate is positioned in said chamber.

**60.** The method of claim 6, wherein said deposition temperature is varied while said substrate is positioned in said chamber.

**61.** The method of claim 6, wherein the pressure in said chamber is varied while said substrate is positioned in said chamber.

**62.** The method of claim 6, wherein said substrate is heated inside said chamber at a temperature lower than 450°C at least twice.

**63.** The method of claim 6, wherein said substrate is heated inside said chamber at a temperature lower than 450°C in the presence of at least one of $O_2$ and $O_3$.

**Patentansprüche**

**1.** Verfahren zur Bildung eines Films auf einem Substrat, welches umfasst:

Platzieren des Substrats in eine CVD-Kammer;

Erhitzen des Substrats auf eine Temperatur von über 300 °C und unter 450 °C; und

Zuführen von Dämpfen eines Bi Oxid-Vorgängers zum Substrat, wobei der Vorgänger mindestens eine Amidgruppe enthält, der Vorgänger an der Oberfläche des Substrats durch Zersetzung Bi Oxid bildet, und das Bi Oxid auf die Oberfläche des Substrats aufgedampft wird.

**2.** Verfahren nach Anspruch 1, wobei der Bi Oxid-Vorgänger vor dem Zersetzen in einer Lösung gelöst wird.

**3.** Verfahren nach Anspruch 1, welches weiterhin umfasst:

Zersetzen eines Sr Oxid-Vorgängers und eines Ta Oxid-Vorgängers bei einer Temperatur von unter 450 °C zur Bildung von Sr Oxid bzw. Ta Oxid; und Aufdampfen des Sr Oxids und Ta Oxids auf das Substrat bei einer Temperatur von unter 450 °C.

**4.** Verfahren nach Anspruch 1, das ferner das Umwandeln des Films in einen ferroelektrischen Film mittels eines Einbrennprozesses umfasst.

**5.** Verfahren nach Anspruch 1, wobei der Film als ferroelektrischer Film aufgedampft wird.

**6.** Verfahren nach Anspruch 3, welches ferner umfasst:

Platzieren des Substrates in eine Kammer;

Erhitzen des Substrats auf eine Aufdampfungstemperatur von unter 450 °C;

Einleiten der Dämpfe des Bi Oxid-Vorgängers, des Sr-Oxid-Vorgängers und des Ta Oxid-Vorgängers in die Kammer;

Zersetzen der Bi, Sr und Ta Oxid-Vorgänger in ihre entsprechenden Oxide; und

Aufdampfen der Oxide auf das Substrat.

**7.** Verfahren nach Anspruch 6, wobei das Zersetzen der Vorgänger umfasst:

Einführen eines Oxidationsmittels in die Kammer; und

Umwandeln der Vorgänger in die Oxide mittels oxidativer Zersetzung.

**8.** Verfahren nach Anspruch 7, wobei das Oxidationsmittel mindestens eines der folgenden umfasst: $O_2$, Singulett $O_2$, $O_3$, $H_2O_2$, $N_2O$, $NO_x$, wobei x 1, 2 oder 3 ist, und stromabwärtiges Sauerstoff-Plasma.

**9.** Verfahren nach Anspruch 8, wobei das Oxidationsmittel zwischen 5 % und 95 % des Gesamtgas- und Dampfflusses in die Kammer ausmacht.

**10.** Verfahren nach Anspruch 7, wobei mindestens zwei verschiedene Oxidationsmittel in die Kammer eingeführt werden.

**11.** Verfahren nach Anspruch 8, wobei das Oxidationsmittel mindestens eines von $O_2$ und $N_2O$ umfasst.

**12.** Verfahren nach Anspruch 7, wobei das Oxidationsmittel durch Umwandlung eines Moleküls in der Kammer in ein aktives Oxidationsmittel gebildet wird, indem mindestens eines der folgenden angewendet wird: Plasma, UV-Licht, Wärme, ein Sensibilisator und Ionenstrahlen.

**13.** Verfahren nach Anspruch 1, wobei der Bi Oxid-Vorgänger die Formel $Bi(NR_2)_3$, $Bi(NR_2)_2(L)$ oder $Bi(NRR')_3$ aufweist, worin L NR'', Alkoxyamin, Alkylendiamin oder P-Ketoamidat ist, und worin jedes von R, R' und R'' unabhängig eine Alkylgruppe oder eine Arylgruppe ist.

**14.** Verfahren nach Anspruch 13, wobei der Bi Oxid-Vorgänger $Bi(NR_2)_3$ ist, worin R tPentyl, Pentyl, tBu, Bu, iPr, Pr, Et, Me, Ph, Aryl oder $SiR''_3$ ist und worin R'' tBu, Bu, $^iPr$, Pr, Et oder Me ist.

**15.** Verfahren nach Anspruch 1, wobei der Bi Oxid-Vorgänger ein Donatoratom enthält, das aus der Gruppe bestehend aus N, 0 und S ausgewählt wird.

**16.** Verfahren nach Anspruch 1, wobei der Film mindestens eines der folgenden enthält: Ca, Ba, Pb, Na, Fe, Al, Sc, Y, Ti, Nb, W, Mo, Ce, La, Pr, Ho, Eu und Yb.

**17.** Verfahren nach Anspruch 16, wobei der Film eine Verbindung der Formel $(Bi_2O_2)^{2+}(A_{m-1}B_mO_{3m+1})^{2-}$ umfasst, worin A $Bi^{3+}$, $L^{3+}$, $L^{2+}$, $Ca^{2+}$, $Sr^{2+}$, $Ba^{2+}$, $Pb^{2+}$ oder $Na^+$ ist, B $Fe^{3+}$, $Al^{3+}$, $Sc^{3+}$, $Y^{3+}$, $L^{3+}$, $L^{4+}$, $Ti^{4+}$, $Nb^{5+}$, $Ta^{5+}$, $W^{6+}$ oder $Mo^{6+}$ ist, worin L aus der Gruppe bestehend aus $Ce^{4+}$, $La^{3+}$, $Pr^{3+}$, $Ho^{3+}$, $Eu^{2+}$ und $Yb^{2+}$ ausgewählt wird, und m 1, 2, 3, 4 oder 5 ist.

**18.** Verfahren nach Anspruch 1, wobei der Film eine Verbindung umfasst, die aus der Gruppe bestehend aus

$Bi_2WO_6$;
$BiMO_3$, worin M Fe oder Mn ist;
$Ba_2BiMO_6$, worin M V, Nb oder Ta ist;
$Pb_2BiMO_6$, worin M V, Nb oder Ta ist;
$Ba_3Bi_2MO_9$, worin M Mo oder W ist;
$Pb_3Bi_2MO_9$, worin M Mo oder W ist;

$Ba_6BiMO_{18}$, worin M Mo oder W ist;
$Pb_6BiMO_{18}$, worin M Mo oder W ist;
$KBiTi_2O_6$; und
$K_2BiNb_5O_{15}$

ausgewählt wird.

**19.** Verfahren nach Anspruch 3, wobei der Film eine Verbindung umfasst, die aus der Gruppe bestehend aus

$SrBi_2Ta_2O_9$;
$SrBi_2Ta_{2-x}Nb_xO_9$, worin $0 \leq x \leq 2$ ist;
$SrBi_2Nb_2O_9$;
$Sr_{1-x}Ba_xBi_2Ta_{2-y}Nb_yO_9$, worin $0 \leq x \leq 1$ und $0 \leq y \leq 2$ ist;
$Sr_{1-x}Ca_xBi_2Ta_{2-y}Nb_yO_9$, worin $0 \leq x \leq 1$ und $0 \leq y \leq 2$ ist;
$Sr_{1-x}Pb_xBi_2Ta_{2-y}Nb_yO_9$, worin $0 \leq x \leq 1$ und $0 \leq y \leq 2$ ist; und
$Sr_{1-x-y-z}Ba_xCa_yPb_zBi_2Ta_{2-p}Nb_pO_9$, worin $0 \leq x \leq 1$, $0 \leq y \leq 1$, $0 \leq z \leq 1$ und $0 \leq p \leq 2$ ist,

ausgewählt wird.

**20.** Verfahren nach Anspruch 19, wobei mindestens ein Element der Verbindung durch ein aus der Gruppe bestehend aus Ce, La, Pr, Ho, Eu und Yb ausgewähltes Metall substituiert wird.

**21.** Verfahren nach Anspruch 3, wobei der Sr Oxid-Vorgänger $Sr(thd)_2$ oder $Sr(thd)_2$ Addukt ist.

**22.** Verfahren nach Anspruch 21, wobei der Sr Oxid-Vorgänger mindestens ein Polyether oder ein Polyamin umfasst.

**23.** Verfahren nach Anspruch 22, wobei das Polyether die Formel $R-O-(CH_2CH_2O)_n-R'$ aufweist, worin $2 \leq n \leq 6$ ist und worin jedes von R und R' unabhängig eine Alkylgruppe, eine Arylgruppe oder Wasserstoff ist.

**24.** Verfahren nach Anspruch 22, wobei das Polyamin die Formel $R-NR''-(CH_2CH_2NR'')_n-R'$ aufweist, worin $2 \leq n \leq 6$ ist, worin jedes von R und R' unabhängig eine Alkylgruppe, eine Arylgruppe oder Wasserstoff ist und worin R'' H, Me, Et oder Pr ist.

**25.** Verfahren nach Anspruch 22, wobei der Sr Oxid-Vorgänger mindestens eines der folgenden umfasst: Tetraglyme, Triglyme, N,N,N',N'',N''-Pentamethyldiethylentriamin und N,N,N',N'',N''',N'''-Hexamethyltriethylentetramin.

**26.** Verfahren nach Anspruch 3, wobei der Ta Oxid-Vorgänger die Formel $Ta(OR)_{5-n}(X)_n$ aufweist, worin R Me, Et, Pr, $^iPr$, Bu, $^iBu$, tBu, Pentyl oder $^iPentyl$ ist,

worin X β-Diketonat ist, und worin n 1, 2, 3, 4 oder 5 ist.

27. Verfahren nach Anspruch 26, wobei der Ta Oxid-Vorgänger Ta(O^iPr)$_4$(thd) ist.

28. Verfahren nach Anspruch 3, wobei mindestens einer der Vorgänger in einer Lösung gelöst wird, die mindestens ein aliphatisches, cycloaliphatisches oder aromatisches Lösungsmittel enthält, wobei das Lösungsmittel mindestens eine funktionelle Gruppe aufweist, die aus der Gruppe bestehend aus einer Alkohol-, Ether-, Ester-, Amin-, Keton- und Aldehydgruppe ausgewählt wird.

29. Verfahren nach Anspruch 28, wobei die Sr und Ta Oxid-Vorgänger jeweils in einer Mischung aus THF, ^iPrOH und Tetraglyme in einem Verhältnis von ca. 8:2:1 gelöst werden.

30. Verfahren nach Anspruch 28, wobei die Sr und Ta Oxid-Vorgänger jeweils in einer Mischung aus Octan, Decan und Pentamethyldiethylentriamin in einem Verhältnis von ca. 5:4:1 gelöst werden.

31. Verfahren nach Anspruch 28, wobei die Sr und Ta Oxid-Vorgänger in Butylacetat gelöst werden.

32. Verfahren nach Anspruch 28, wobei der Bi Oxid-Vorgänger in Octan gelöst wird.

33. Verfahren nach Anspruch 28, wobei die Lösung von mindestens einem Verdampfer verdampft wird.

34. Verfahren nach Anspruch 33, wobei ein Inertgas zu den Dämpfen der Lösung hinzugefügt und eine Mischung ans dem Inertgas und den Dämpfen in die Kammer eingeleitet wird, wobei das Inertgas mindestens eines von Ar, He und N$_2$ enthält.

35. Verfahren nach Anspruch 34, wobei die Mischung Dämpfe der Bi, Sr und Ta Oxid-Vorgänger in einem Verhältnis von ca. 2:1:2 enthält.

36. Verfahren nach Anspruch 6, wobei der Druck in der Kammer zwischen 0,1333 und 1,013•10$^3$ Pa (0,001-760 Torr) beträgt.

37. Verfahren nach Anspruch 36, wobei der Druck in der Kammer zwischen 13,33 und 1,333•10$^3$ Pa (0,1 - 10 Torr) beträgt.

38. Verfahren nach Anspruch 7, wobei ein zusätzliches Inertgas in die Kammer eingeleitet wird, wobei das Inertgas mindestens eines von Ar, He und N$_2$ enthält, und wobei das zusätzliche Inertgas zwischen 10 % und 90 % des Gesamtgas- und Dampfflusses in die Kammer ausmacht.

39. Verfahren nach Anspruch 3, wobei die Oxide über eine Zeitspanne zwischen 2 Minuten und 2 Stunden auf das Substrat aufgedampft werden.

40. Verfahren nach Anspruch 39, wobei die Oxide über eine Zeitspanne zwischen 2 und 15 Minuten auf das Substrat aufgedampft werden.

41. Verfahren nach Anspruch 4, wobei der Film über eine Zeitspanne zwischen 5 Minuten und 3 Stunden auf eine Temperatur zwischen 600 °C und 800 °C erhitzt wird.

42. Verfahren nach Anspruch 33, wobei Dämpfe, die im Wesentlichen aus dem Bi Oxid-Vorgänger bestehen, während einer Zeitspanne ab Beginn der Aufdampfung bis 30 Minuten danach in die Kammer eingeleitet werden.

43. Verfahren nach Anspruch 1, wobei das Substrat mindestens eines der folgenden enthält: Si, n-dotiertes Si, p-dotiertes Si, SiO$_2$, Si$_3$N$_4$, GaAs, MgO, Al$_2$O$_3$, ZrO$_2$, SrTiO$_3$, BaTiO$_3$ und PbTiO$_3$ enthält.

44. Verfahren nach Anspruch 1, wobei der Film auf eine auf dem Substrat angeordnete untere Elektrode aufgedampft wird, wobei das Substrat einen Transistor darin umfasst, und die untere Elektrode mit dem Transistor über einen Stecker verbunden ist.

45. Verfahren nach Anspruch 44, wobei die untere Elektrode mindestens eines der folgenden umfasst:

Ein Metall, das aus der Gruppe bestehend aus Pt, Pd, Au, Ir und Rh ausgewählt wird;

Ein leitendes Metalloxid, das aus der Gruppe bestehend aus IrOx, RhOx, RuOx, OSOx, ReOx, WOx, worin x 0, 1 oder 2 ist, ausgewählt wird;

Ein leitendes Metallnitrid, das aus der Gruppe bestehend aus TiN$_y$, ZrN$_x$ und WN$_y$TaN$_y$, worin 0≤x≤1,0 und 0≤y≤1,7 ist, ausgewählt wird; und

Ein superleitendes Oxid, das aus der Gruppe bestehend aus YBa$_2$Cu$_3$O$_{7-x}$, worin 0≤x≤1 ist, und Bi$_2$SnCa$_2$Cu$_3$O$_{10}$ ausgewählt wird.

46. Verfahren nach Anspruch 44, wobei die untere Elektrode eine Pt-Elektrode ist.

47. Verfahren nach Anspruch 44, wobei mindestens eine erste Zwischenschicht zwischen der unteren Elektrode und dem Stecker vorgesehen ist, und die erste Zwischenschicht eine Adhäsionsschicht und/oder eine Diffusionssperrschicht enthält.

**48.** Verfahren nach Anspruch 44, wobei mindestens eine zweite Zwischenschicht zwischen der unteren Elektrode und dem Metalloxidfilm vorgesehen ist, und die zweite Zwischenschicht eine Saatschicht und/oder eine leitende Schicht und/oder eine dielektrische Schicht enthält.

**49.** Verfahren nach Anspruch 44, wobei der Stecker mit der unteren Elektrode und einer Drain des ferroelektrischen MOS-Effekt-Transistors verbunden ist, wobei der Stecker im Wesentlichen aus W oder Si besteht.

**50.** Verfahren nach Anspruch 44, wobei der Film als dünner ferroelektrischer Film für einen ferroelektrischen Kondensator benutzt wird.

**51.** Verfahren nach Anspruch 44, wobei der Film als dünner ferroelektrischer Film für einen ferroelektrischen Speicher benutzt wird.

**52.** Verfahren nach Anspruch 51, wobei der Film als dünner ferroelektrischer Film für einen ferroelektrischen Feldeffekttransistor benutzt wird.

**53.** Verfahren nach Anspruch 7, wobei das Substrat, bevor es den Dämpfen der Metalloxid-Vorgänger ausgesetzt wird, mit einer Mischung aus einem Inertgas und dem Oxidationsmittel geflusht wird.

**54.** Verfahren nach Anspruch 7, wobei das Substrat, nachdem es den Dämpfen der Vorgänger ausgesetzt wurde, mit einer Mischung aus einem Inertgas und dem Oxidationsmittel geflusht wird.

**55.** Verfahren nach Anspruch 6, wobei mindestens einer der Erhitzungs-, Zersetzungs- und Aufdampfungsprozesse mindestens zweimal anf dem Substrat durchgeführt wird.

**56.** Verfahren nach Anspruch 7, wobei das Substrat aus der Kammer entfernt, mit mindestens einem Zwischenprozess behandelt und wieder in die Kammer eingeführt wird.

**57.** Verfahren nach Anspruch 28, wobei die Zusammensetzung der Vorgänger in der Mischung variiert wird, während sich das Substrat in der Kammer befindet.

**58.** Verfahren nach Anspruch 26, wobei die Zusammensetzung des Inertgases in der Mischung variiert wird, während sich das Substrat in der Kammer befindet.

**59.** Verfahren nach Anspruch 7, wobei die Zusammensetzung des Oxidationsmittels variiert wird, während sich das Substrat in der Kammer befindet.

**60.** Verfahren nach Anspruch 6, wobei die Zersetzungstemperatur variiert wird, während sich das Substrat in der Kammer befindet.

**61.** Verfahren nach Anspruch 6, wobei der Druck in der Kammer variiert wird, während sich das Substrat in der Kammer befindet.

**62.** Verfahren nach Anspruch 6, wobei das Substrat innerhalb der Kammer bei einer Temperatur von unter 450 °C mindestens zweimal erhitzt wird.

**63.** Verfahren nach Anspruch 6, wobei das Substrat innerhalb der Kammer bei einer Temperatur von unter 450 °C in Gegenwart von $O_2$ und/oder einem $O_3$ erhitzt wird.

**Revendications**

**1.** Procédé de formation d'une pellicule sur un substrat, le procédé comprenant :

la mise en place du substrat dans une chambre de CVD ; le chauffage du substrat à une température supérieure à 300°C et inférieure à 450°C ; et
l'introduction de vapeurs d'un précurseur d'oxyde de Bi sur le substrat, le précurseur comprenant au moins un groupe amide, le précurseur se décomposant à la surface du substrat pour former de l'oxyde de Bi, l'oxyde de Bi étant déposé à la surface du substrat.

**2.** Procédé selon la revendication 1,
dans laquelle le précurseur d'oxyde de Bi est dissous dans une solution avant d'être décomposé.

**3.** Procédé selon la revendication 1,
comprenant en outre, la décomposition d'un précurseur d'oxyde de Sr et d'un oxyde de Ta à une température inférieure à 450°C pour former l'oxyde de Sr et l'oxyde de Ta, respectivement, et le dépôt de l'oxyde de Sr et de l'oxyde de Ta sur le substrat à une température inférieure à 450°C.

**4.** Procédé selon la revendication 1,
comprenant en outre la transformation de la pellicule en une pellicule ferroélectrique par un procédé de recuit.

**5.** Procédé selon la revendication 1,
dans lequel
la pellicule est déposée sous la forme d'une pellicule ferroélectrique.

**6.** Procédé selon la revendication 3, dans lequel le procédé comprend en outre : la mise en place du substrat dans une chambre ; le chauffage du substrat à une température de dépôt inférieure à 450°C ; l'introduction de vapeurs du précurseur d'oxyde de Bi, du précurseur d'oxyde de Sr et du précurseur d'oxyde de Ta dans la chambre ; la décomposition des précurseurs d'oxyde de Bi, d'oxyde de Sr et d'oxyde de Ta en leurs oxydes ; et le dépôt des oxydes sur le substrat.

**7.** Procédé selon la revendication 6, dans lequel la décomposition des précurseurs comprend :

l'introduction d'un oxydant dans la chambre ; et la transformation des précurseurs en les oxydes au moyen d'une décomposition par oxydation.

**8.** Procédé selon la revendication 7, dans lequel l'oxydant comprend au moins $O_2$, un singulet d'$O_2$, $O_3$, $H_2O_2$, $N_2O$, $NO_x$, où x vaut 1, 2 ou 3, un plasma d'oxygène en aval.

**9.** Procédé selon la revendication 8, dans lequel l'oxydant occupe entre 5 % et 95 % du débit total de gaz et de vapeur dans la chambre.

**10.** Procédé selon la revendication 7, dans lequel on introduit dans la chambre au moins deux oxydants différents.

**11.** Procédé selon la revendication 8, dans lequel l'oxydant comprend au moins $O_2$ ou $N_2O$.

**12.** Procédé selon la revendication 7, dans lequel l'oxydant est formé par transformation d'une molécule dans la chambre en un oxydant actif par application d'au moins un plasma, une lumière UV, de la chaleur, un sensibilisateur, ou de faisceaux d'ions.

**13.** Procédé selon la revendication 1, dans lequel le précurseur d'oxyde de Bi répond à la formule Bi$(NR_2)_3$, Bi$(NR_2)_2$(L) ou Bi(NRR')$_3$, où L représente NR", une alcoxyamine, une alkylène diamine ou un P-cétoamidate et où chacun des radicaux R, R' et R" représente, indépendamment, un groupe alkyle ou un groupe aryle.

**14.** Procédé selon la revendication 13,

dans lequel le précurseur d'oxyde de Bi est Bi$(NR_2)_3$, où R représente le t-pentyle, le pentyle, le tBu, Bu, $^{i}$Pr, Pr, Et, Me, Ph, aryle ou SiR"3 et dans laquelle R" représente tBu, Bu, $^{i}$Pr, Pr, Et ou Me.

**15.** Procédé selon la revendication 1, dans lequel le précurseur d'oxyde de Bi comprend un atome donneur choisi dans le groupe constitué par N, O et S.

**16.** Procédé selon la revendication 1, dans lequel la pellicule comprend au moins l'un des éléments Ca, Ba, Pb, Na, Fe, Al, Sc, Y, Ti, Nb, W, Mo, Ce, La, Pr, Ho, Eu et Yb.

**17.** Procédé selon la revendication 16, dans lequel la pellicule comprend un composé répondant à la formule $_{(Bi_2O_2)^{2+}}(A_{m-1}B_mO_{3m+1})^{2-}$, dans laquelle A représente Bi$^{3+}$, L$^{3+}$, L$^{2+}$, Ca$^{2+}$, Sr$^{2+}$, Ba$^{2+}$, Pb$^{2+}$ ou Na$^+$, B représente Fe$^{2+}$, Al$^{3+}$, Sc$^{3+}$, Y$^{3+}$, L$^{3+}$, L$^{4+}$, Ti$^{4+}$, Nb$^{5+}$, Ta$^{5+}$, W$^{6+}$ ou Mo$^{6+}$, où L est choisi dans le groupe constitué par Ce$^{4+}$, La$^{3+}$, Pr$^{3+}$, Ho$^{3+}$, Eu$^{2+}$ et Yb$^{2+}$ et m vaut 1, 2, 3, 4 ou 5.

**18.** Procédé selon la revendication 1, dans lequel la pellicule comprend un composé choisi dans le groupe constitué par :

$Bi_2WO_6$
BiM $O_3$ où M représente Fe ou Mn,
$Ba_2BiMO_6$ où M représente V, Nb ou Ta ;
$Pb_2BiMO_6$ où M représente V, Nb ou Ta ;
$Ba_3Bi_2MO_9$ où M représente Mo ou W ;
$Pb_3Bi_2MO_9$ où M représente Mo ou W ;
$Ba_6BiMO_{18}$ où M représente Mo ou W ;
$Pb_6BiMO_{18}$ où M représente Mo ou W ;
$KBiTi_2O_6$ et
$K_2BiNb_5O_{15}$.

**19.** Procédé selon la revendication 3, dans lequel la pellicule comprend un composé choisi dans le groupe constitué par

$SrBi_2Ta_2O_9$:
$SrBi_2Ta_{2-x}Nb_xO_9$, où $0{\leq}x{\leq}2$ ;
$SrBi_2Nb_2O_9$ ;
$Sr_{1-x}Ba_xBi_2Ta_{2-y}Nb_yO_9$ où $0{\leq}x{\leq}1$ et $0{\leq}y{\leq}2$ ;
$Sr_{1-x}Ca_xBi_2Ta_{2-y}Nb_yO_9$ où $0{\leq}x{\leq}1$ et $0{\leq}y{\leq}2$ ;
$Sr_{1-x}Pb_xBi_2Ta_{2-y}Nb_yO_9$ où $0{\leq}x{\leq}1$ et $0{\leq}y{\leq}2$ ;
$Sr_{1-x-y-z}BaCa_yPb_zTa_{2-p}Nb_pO_9$ où $0{\leq}x{\leq}1$, $0{\leq}y{\leq}1$, $0{\leq}z{\leq}1$ et $0{\leq}p{\leq}2$.

**20.** Procédé selon la revendication 19, dans lequel au moins un élément du composé est substitué par un métal choisi dans le groupe constitué par Ce, La, Pr, Ho, Eu et Yb.

**21.** Procédé selon la revendication 3, dans lequel le précurseur d'oxyde de Sr est Sr(thd)$_2$ ou un produit d'addition de Sr(thd)$_2$.

**22.** Procédé selon la revendication 21, dans lequel le précurseur d'oxyde de Sr comprend au moins un polyéther ou une polyamine.

**23.** Procédé selon la revendication 22, dans lequel le polyéther répond à la formule R-O-(CH$_2$CH$_2$O)$_n$-R$^1$ où 2≤n≤b et où chacun des radicaux R et R' représente, indépendamment, un groupé alkyle, un groupe aryle ou un hydrogène.

**24.** Procédé selon la revendication 22, dans lequel la polyamine répond à la formule N-NR"-(CH$_2$CH$_2$NR")$_n$-R, où 2≤n≤6 , où chacun des radicaux R et R' représentent, indépendamment, un groupe alkyle, un groupe aryle, ou un hydrogène, et où R" représente H, Me, Et ou Pr.

**25.** Procédé selon la revendication 22, dans lequel le précurseur d'oxyde de Sr comprend au moins le tétraglyme, le tryglyme, la N,N,N',N",N"-pentaméthyldiéthylène-triamine ou la N,N,N',N",N"',N"'-hexaméthyl-triéthylène-tétramine.

**26.** Procédé selon la revendication 3, dans lequel le précurseur d'oxyde de Ti répond à la formule Ta(OR)$_{5-n}$(x)$_n$ dans laquelle R représente Me, Et, Pr, Tr, Bu, 'Bu, tBu, pentyle ou $^i$pentyle, où X représente le ss-dicétonate, et où n vaut 1, 2, 3, 4 ou 5.

**27.** Procédé selon la revendication 26, dans lequel le précurseur d'oxyde de Ta est Ta(OiPr)$_4$(thd).

**28.** Procédé selon la revendication 3, dans lequel au moins l'un des précurseurs est dissous dans une solution comprenant au moins un solvant aliphatique, cycloaliphatique ou aromatique, le solvant ayant au moins un groupe fonctionnel choisi dans le groupe constitué par un alcool, un éther, un ester, une amine, une cétone ou un aldéhyde.

**29.** Procédé selon la revendication 28, dans lequel les précurseurs d'oxyde de Sr et d'oxyde de Ta sont dissous dans un mélange de THF, de $^i$PrOH et de tétraglyme dans un rapport de 8 :2 :1, respectivement.

**30.** Procédé selon la revendication 28, dans lequel les précurseurs d'oxyde de Sr et d'oxyde de Ta sont dissous dans un mélange d'octane, de décane et de pentaméthyldiéthylène diamine dans un rapport d'environ 5 :4 :1, respectivement.

**31.** Procédé selon la revendication 28, dans lequel les précurseurs d'oxyde de Sr et d'oxyde de Ta sont dissous dans l'acétate de butyle.

**32.** Procédé selon la revendication 28, dans lequel le précurseur d'oxyde de Bi est dissous dans l'octane.

**33.** Procédé selon la revendication 28, dans lequel on fait évaporer la solution avec au moins un vaporisateur.

**34.** Procédé selon la revendication 33, dans lequel on ajoute un gaz inerte aux vapeurs de la solution et on fournit un mélange du gaz inerte et de vapeurs dans la chambre, le gaz inerte comprenant au moins Ar, He ou N$_2$.

**35.** Procédé selon la revendication 34, dans lequel le mélange comprend des vapeurs du précurseur d'oxyde de Bi, d'oxyde de Sr et d'oxyde de Ta dans un rapport d'environ 2 :1 :2.

**36.** Procédé selon la revendication 6, dans lequel la pression dans la chambre est comprise entre 0,1333 et 1,013 x 10$^3$ Pa (0,001-760 torr).

**37.** Procédé selon la revendication 36, dans lequel la pression dans la chambre est comprise entre 13,33 et 1,333 x 10$^3$ Pa (0,1-10 torr).

**38.** Procédé selon la revendication 7, dans lequel on ajoute un gaz inerte supplémentaire à la chambre, le gaz inerte comprenant au moins Ar, H$_2$ ou N$_2$, et le gaz inerte additionnel occupant entre 10 % et 90 % du débit total de gaz et de vapeur dans la chambre.

**39.** Procédé selon la revendication 3,
dans lequel
on dépose les oxydes sur le substrat pendant une durée comprise entre 2 minutes et 2 heures.

**40.** Procédé selon la revendication 39,
dans lequel
on dépose les oxydes sur le substrat pendant une durée comprise entre 2 minutes et 15 minutes.

**41.** Procédé selon la revendication 4,
dans lequel
on chauffe la pellicule entre une température comprise entre 600°C et 800°C pendant une durée comprise entre 5 minutes et 3 heures.

**42.** Procédé selon la revendication 33,
dans lequel
on fournit des vapeurs consistant essentiellement en les précurseurs d'oxyde de Bi à la chambre pendant une période comprise entre le début du dépôt et les 30 minutes qui suivent.

**43.** Procédé selon la revendication 1,
dans lequel
le substrat comprend au moins l'un des corps suivants : Si, Si n-dopé, Si p-dopé, $SiO_2$, $Si_3N_4$, GaAs, MgO, $Al_2O_3$, $ZrO_2$, $SrTiO_3$, $BaTiO_3$ et $PbTiO_3$.

**44.** Procédé de la revendication 1,
dans lequel
la pellicule est déposée sur une électrode de fond déposée sur le substrat, le substrat comprenant un transistor, l'électrode de fond étant connectée au transistor par une fiche de connexion.

**45.** Procédé selon la revendication 44,
dans lequel
l'électrode de fond comprend au moins l'un des corps suivants :

un métal choisi dans le groupe constitué par Pt, Pd, Au, Ir et Rh ;
un oxyde métallique conducteur choisi dans le groupe constitué par $IrO_x$, RhOx, RuOx, OSOx, ReOx, WOx, où x vaut 0, 1 ou 2 ;
un nitrure métallique conducteur choisi dans le groupe constitué par TINY, ZrNX et WNyTaNy, où $0 \leq x \leq 1,0$ et $0 \leq y \leq 1,7$ ; et un oxyde supraconducteur choisi dans le groupe constitué par $YBa_2Cu_3O_{7-x}$ où $0 \leq x \leq 1$ et $Bi_2SnCa_2Cu_3O_{10}$.

**46.** Procédé selon la revendication 44,
dans lequel
l'électrode de fond est une électrode en Pt.

**47.** Procédé selon la revendication 44,
dans lequel
au moins une première couche intermédiaire est fournie entre l'électrode de fond et la fiche de connexion, la première couche intermédiaire comprenant au moins une couche d'adhérence et une couche formant barrière de diffusion.

**48.** Procédé selon la revendication 44,
dans lequel
au moins une seconde couche intermédiaire est fournie entre l'électrode de fond et la pellicule d'oxyde métallique, la seconde couche intermédiaire comprenant au moins une couche d'ensemencement, une couche conductrice ou une couche diélectrique.

**49.** Procédé selon la revendication 44,
dans lequel
la fiche de connexion est reliée à l'électrode de fond et à un drain d'un transistor à effet ferroélectrique de type MOS, la fiche de connexion consistant essentiellement en W ou en Si.

**50.** Procédé selon la revendication 44,
dans lequel
la pellicule est utilisée comme pellicule ferroélectrique mince pour une capacité ferroélectrique.

**51.** Procédé selon la revendication 44,
dans lequel
la pellicule est utilisée comme pellicule ferroélectrique mince pour une mémoire ferroélectrique.

**52.** Procédé selon la revendication 51,
dans lequel
la pellicule est utilisée comme pellicule ferroélectrique mince pour un transistor à effet de champ ferroélectrique.

**53.** Procédé selon la revendication 7,
dans lequel
on balaye le substrat avec un mélange d'un gaz inerte et du dioxydant avant de l'exposer aux vapeurs des précurseurs des oxydes métalliques.

**54.** Procédé selon la revendication 7,
dans lequel
on balaye le substrat avec un mélange d'un gaz inerte et de l'oxydant après l'avoir exposé aux vapeurs des précurseurs.

**55.** Procédé selon la revendication 6,
dans lequel
on effectue au moins deux fois sur ledit substrat l'un desdits procédés de chauffage, de décomposition et de dépôt.

**56.** Procédé selon la revendication 7, dans lequel on retire le substrat de la chambre, on le traite par au moins un procédé intermédiaire, et on le renvoie dans la chambre.

**57.** Procédé selon la revendication 28, dans lequel on fait varier la composition des précurseurs dans le mélange tandis que le substrat est positionné dans la chambre.

**58.** Procédé selon la revendication 26, dans lequel on fait varier la composition du gaz inerte dans le mélange tandis que le substrat est positionné dans la chambre.

**59.** Procédé de la revendication 7, dans lequel on fait varier la composition de l'oxydant tandis que le substrat est positionné dans la chambre.

**60.** Procédé selon la revendication 6, dans lequel on fait varier la température de dépôt tandis que le substrat est positionné dans la chambre.

**61.** Procédé selon la revendication 6, dans lequel on fait varier la pression dans la chambre tandis que le substrat est positionné dans la chambre.

**62.** Procédé selon la revendication 6, dans lequel on chauffe le substrat à l'intérieur de la chambre à une température inférieure à 450°C au moins deux fois.

**63.** Procédé selon la revendication 6, dans lequel on chauffe le substrat à l'intérieur de la chambre à une température inférieure à 450°C en présence d'au moins $O_2$ ou $O_3$.

FIG. 1

FIG. 2

Fig.3    STA of Bi(NMe₂)₃ in (a) argon and (b) oxygen.

2 Theta (deg)

Fig.4    Powder XRD of α-Bi₂O₃ from oxidation of Bi(NMe₂)₃ after heating to 500 °C.

Fig.5

STA of Bi(NPh₂)₃ in (a) argon and (b) oxygen.

Fig.6

STA of Bi(N(SiMe₃)₂)₃ in (a) argon and (b) oxygen.

*Fig. 7*  Comparison of powder XRD of oxidation product of Bi(N(SiMe3)2)3 to Bi12O20Si.  Residue from STA following heating to 500 °C under oxygen.

*Fig. 8*  EDS of oxidation product of Bi(N(SiMe3)2)3.